# EUROPÄISCHE PATENTSCHRIFT

(11) **EP 1 586 908 B1**
(45) Veröffentlichungstag und Bekanntmachung des Hinweises auf die Patenterteilung: **12.05.2010**
(21) Anmeldenummer: 05007360.0
(22) Anmeldetag: 05.04.2005
(51) Int. Cl.: G01R 11/02, G01R 11/04

(54) **Anschlussvorrichtung für einen Stromzähler**
Mounting adapter for an electricity meter
Dispositif de connexion pour un compteur d'électricité

(30) Priorität: 16.04.2004 DE 102004019129; 19.05.2004 DE 102004025605
(43) Veröffentlichungstag der Anmeldung: 19.10.2005
(73) Patentinhaber: Hager Electro GmbH & Co. KG, 66440 Blieskastel (DE)
(72) Erfinder: Clemens, Guntram, Dr.-Ing., 90409 Nürnberg (DE); Zimmermann, Michael, 66399 Mandelbachtal (DE); Kelaiditis, Konstantin, Dr.-Ing., 66386 St.Ingbert (DE)
(74) Vertreter: Bernhardt, Reinold

(56) Entgegenhaltungen:
- DE-A1- 10 052 998
- DE-A1- 10 054 771
- US-A- 5 870 911

## Beschreibung

Die Erfindung betrifft eine Anschlussvorrichtung für einen Stromzähler, der ein Gehäuse aufweist, von dessen gegen eine Tragplatte anlegbarem Boden durch Öffnungen in der Tragplatte hindurchführbare Kontaktelemente entsprechend wenigstens einer Stromphase vorstehen, welche durch Verschiebung des auf der Tragplatte geführten Gehäuses mit stromzu- und -abführenden Anschlusselementen auf der dem Stromzähler abgewandten Seite der Tragplatte verbindbar sind, wobei die Anschlusselemente durch ein in Verschiebungsrichtung des Stromzählers verschiebbar geführtes Teil überbrückbar sind und das Überbrückungsteil beim Anschluss des Stromzählers durch den Stromzähler aus einer Überbrückungsposition in eine Offenstellung verschiebbar ist.

Bei einer solchen, aus der DE 103 13 999 A1 bekannten Anschlussvorrichtung greift das Kontaktelement in eine Ausnehmung in dem Überbrückungsteil ein, so dass das Überbrückungsteil bei Verschiebung des Zählers mitgenommen und in die Offenstellung überführt wird, während die Kontaktelemente mit Anschlussleitern verbunden werden.

Aus der DE 100 52 998 A1 geht eine Anschlussvorrichtung hervor, bei der das Überbrückungsteil durch Federkontaktelemente mit abgebogenen Schenkeln gebildet ist, die in der Überbrückungsposition miteinander in Kontakt stehen und durch Verschiebung des Stromzählers unter Verbiegung der Schenkel durch die Kontaktelemente des Stromzählers dadurch in die Offenstellung gebracht werden, dass kein Kontakt mehr zwischen den Schenkeln besteht.

Der vorliegenden Erfindung liegt die Aufgabe zugrunde, eine Anschlussvorrichtung der eingangs erwähnten Art derart weiterzubilden, dass eine Verkürzung der Baulänge in Richtung der Verschiebung des Stromzählers möglich ist.

Die diese Aufgabe lösende Vorrichtung nach der Erfindung ist **dadurch gekennzeichnet, dass** und das Überbrückurigsteil und das wenigstens eine Kontaktelement senkrecht zur Verschiebungsrichtung des Zählergehäuses zueinander versetzt angeordnet sind und das Überbrückungsteil durch den Stromzähler mittelbar über ein Zwischenstück verschiebbar ist.

Im Unterschied zum Stand der Technik erfolgt die Verschiebung des Überbrückungsteils nicht unmittelbar durch das Kontaktelement, woraus sich Möglichkeiten insbesondere zur Anordnung von Anschlusselementen derart ergeben, dass sich eine insgesamt kürzere Baulänge erreichen lässt.

Während es denkbar wäre, zur Verschiebung der Überbrückungsteile am Stromzählergehäuse entsprechende Mitnehmer, zusätzliche Öffnungen in der Tragplatte und ein Mitnehmerzwischenstück vorzusehen, erfolgt in der bevorzugten Ausführungsform der Erfindung die Bewegung des Überbrückungsteils durch das Kontaktelement, jedoch mittelbar über ein solches Mitnehmerzwischenstück.

Bei dem Zwischenstück handelt es sich vorzugsweise um eine Öffnungen für die Kontaktelemente aufweisende Platte, mit Einrichtungen zur Mitnahme des Überbrückungsteils.

Zwischen der Mitnehmerplatte und der Tragplatte kann eine weitere, quer zur Verschiebungsrichtung des Gehäuses bewegbare Verschlussplatte zum Verschließen von zu den Anschlusselementen durch die Öffnungen in den Platten führenden Durchgängen gebildet sein, welche zum Einsatz kommt, wenn am Zählerplatz kein Stromzähler angeschlossen ist. Vorzugsweise ist die Verschlussplatte in der Verschlussstellung plombierbar.

In der bevorzugten Ausführungsform der Erfindung weisen die stromzu- und -abführenden Anschlusselemente sich senkrecht zur Verschiebungsrichtung des Zählergehäuses erstreckende Federkontaktschenkel auf. Zwischen diesen Federkontaktschenkeln lassen sich die Kontaktelemente bzw. das Überbrückungsteil seitlich einführen. Vorteilhaft erlauben solche Anschlusselemente kurze, von dem Stromzähler gehäuse nur über eine geringe Länge vorstehende Kontaktelemente.

Vorzugsweise sind einteilige Kontaktstücke mit jeweils zwei senkrecht zur Verschiebungsrichtung des Zählergehäuses zueinander versetzten Paaren von Federkontaktschenkeln vorgesehen. An eines der Federkontaktschenkelpaare wird das jeweilige Kontaktelement angeschlossen. Das andere Federkontaktschenkelpaar dient der Kontaktierung des Überbrückungsteils.

In weiterer Ausgestaltung der Erfindung kann an einem der Federschenkelpaare ein weiterer Federschenkel vorgesehen, welcher mit einem der beiden Federschenkel des betreffenden Federschenkelpaares einen Kontaktschlitz für einen Anschlussleiter bildet. Durch die genannten Maßnahmen lässt sich eine kurze Baulänge der Anschlussvorrichtung in Verschiebungsrichtung des Stromzählers erreichen.

Zweckmäßig sind an den Federkontaktschenkeln die seitliche Einführung des Kontaktelements bzw. Überbrückungsteils erleichternde Leiteinrichtungen gebildet.

Vorzugsweise sind an der Mitnehmerplatte in Verschiebungsrichtung ausgerichtet zu den Öffnungen für die Kontaktelemente Vorsprünge gebildet, welche, bevor es zur Kontaktierung kommt, die Anschlusselementen gegen die Kontaktelemente isolieren bzw. die Anschlusselemente verdecken, so dass bei verkantetem Aufsetzen des Stromzählers auf die Tragplatte keine spannungsführenden Teile freiliegen.

Ferner kann eine beim Aufsetzen des Stromzählergehäuses auf die Tragplatte durch die Kontaktelemente lösbare Verhakung vorgesehen sein, welche verhindert, dass sich die Mitnehmerplatte von außen durch ein allgemein verfügbares Werkzeug, z.B. einen Schraubendreher, verschieben lässt, Bei schrägem Aufsetzen des Stromzählers auf die Tragplatte bleibt die Mitnehmerplatte vorteilhaft so lange in der Ausgangsposition, bis der Stromzähler ordnungsgemäß mit seiner gesamten Bodenfläche gegen die Zählertragplatte anliegt.

In weiterer Ausgestaltung der Erfindung weist der Anschlussleiter einen Blechstreifen und einen an seinem dem Anschlusselement abgewandten Ende eine Kontaktfahne in Form einer bis an einen Randeinschnitt heranreichenden Abkantung auf.

Bei dem obengenannten Kontaktstück kann es sich um einen S-förmig gebogenen Federmaterialstreifen handeln, wobei der Federmaterialstreifen vorzugsweise zur Bildung dreier Paare von Federkontaktschenkeln doppelt S-förmig gebogen sein kann. Ein solches Kontaktstück lässt sich in kurzer Baulänge herstellen, so dass sein Platzbedarf und Eigenwiderstand entsprechend gering sind. Die Verringerung der Baulänge ermöglicht im Gegenzug längere Verschiebewege des Überbrückungsteils. Dies ermöglicht es, ggf. auf die Verschlussplatte zu verzichten. Die Mitnehmerplatte könnte so weit verschoben werden, dass sie die Schlitze verschließt.

Durch ein solches Kontaktelement ergibt sich ferner der Vorteil, dass die Leitungen an den oberen Kontaktfedern nach oben verlegt werden können, was erforderlich ist, wenn das Kontaktstück in einem für den betreffenden Stromzähler vorbereiteten Zählerplatz und nicht in einem Adapter eingesetzt wird.

Die Erfindung wird nachfolgend anhand eines Ausführungsbeispiels und der beiliegenden, sich auf dieses Ausführungsbeispiel beziehenden Zeichnungen näher erläutert. Es zeigen:
- Fig. 1: einen auf einen herkömmlichen Zählerplatz aufsetzbaren Stromzähleradapter mit einer Anschlussvorrichtung nach der Erfindung,
- Fig. 2: den Adapter von Fig. 1 in einer Explosionsdarstellung ohne stromleitende Teile,
- Fig. 3: eine in dem Adapter von Fig. 1 verwendete Mitnehmerplatte,
- Fig. 4: eine Draufsicht auf den hinteren Gehäuseteil des Adapters von Fig. 1 ohne stromführende Teile,
- Fig. 5: eine Teilansicht des hinteren Gehäuseteils mit stromführenden Teilen,
- Fig. 6: ein in dem Adapter von Fig. 1 verwendetes Kontaktstück mit zwei Paaren von Federkontaktschenkeln,
- Fig. 7: ein in dem Adapter von Fig. 1 verwendetes Überbrückungsteil,
- Fig. 8: ein in dem Adapter von Fig. 1 verwendetes Anschlussleiterstück,
- Fig. 9: ein weiteres Ausführungsbeispiel für ein Kontaktstück mit Federkontaktschenkelpaaren, und
- Fig. 10: einen Kontaktstücke gemäß Fig. 9 verwendenden Adapter.

Ein an einen herkömmlichen Zählerplatz montierbarer Adapter 1 für einen (nicht gezeigten) Stromzähler weist einen vorderen Gehäuseteil 2 mit einer Zählertragplatte 4 und einen hinteren Gehäuseteil 3 in Form eines halb offenen Kastens 5 auf.

An die Zählertragplatte 4 und den halb offenen Kasten 5 schließt sich jeweils ein Abschnitt 6 bzw. 7 für die Bildung eines Anschlussleistenteils 50 des Adapters 1 an.

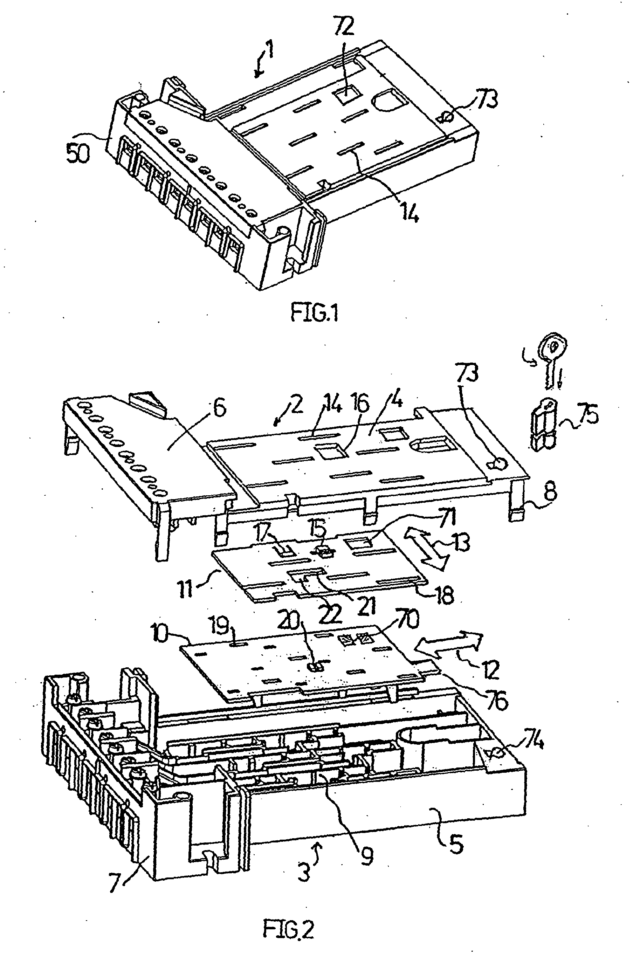

Wie aus Fig. 2 hervorgeht, ist der vordere Gehäuseteil 2 mit dem hinteren Gehäuseteil 3 über einrastende Stecknasen 8 verbindbar.

Vom Boden des unteren Gehäuseteils stehen stegförmig Isolierteile 9 vor, zwischen denen elektrischen Leiter angeordnet und gehalten sind.

Zwischen den Isolierteilen 9 und der Zählertragplatte 4 sind eine Mitnehmerplatte 10 und eine Verschlussplatte 11 angeordnet.

Von den zur Zählertragplatte 4 parallelen Platten 10 und 11 ist die Mitnehmerplatte 10 an dem hinteren Teil 3 des Zählergehäuses geführt und in Richtung eines Pfeils 12 hin und her verschiebbar. Die an der Rückseite der Zählertragplatte 4 geführte Verschlussplatte 11 lässt sich gemäß Pfeil 13 hin und her verschieben.

Die Zählertragplatte 4 weist insgesamt sieben gleich lange Schlitze 14 auf, in welche streifenförmige, von der Unterseite eines Stromzählers vorstehende Kontaktelemente einführbar sind. Sechs Kontaktelemente sind für drei Stromphasen vorgesehen, ein Kontaktelement bildet den zum Betrieb des Stromzählers selbst erforderlichen Nullleiter.

Die Verschlussplatte 11 weist zu den Schlitzen 14 deckungsgleiche Schlitze 18 bzw. Randausnehmungen auf. Von der Verschlussplatte steht eine Nase 15 in ein Fenster 16 in der Zählertragplatte vor. Über die Nase lässt sich die Verschlussplatte 11 gemäß Pfeil 13 verschieben. An der Nase 15 sind ferner Einrichtungen zur Plombierung der Verschlussplatte 11 in ihrer Verschlussstellung vorgesehen, in welcher sie sämtliche Öffnungen in der Tragplatte 4 von hinten verschließt. Eine Rastnase 17 rastet in der Verschlussstellung an der Rückseite der Zählertragplatte 4 ein.

Die Mitnehmerplatte 10 weist den Schlitzen 14 in der Zählertragplatte 4 entsprechende Schlitze 19 auf, die jedoch kürzer als die Schlitze 14 sind und deren Länge in Verschiebungsrichtung gemäß Pfeil 12 gleich der Breite der streifenförmigen, von der Rückseite des (nicht gezeigten) Stromzählers vorstehenden Kontaktelementen ist. Eine Nase 20 auf der Mitnehmerplatte 10 ragt in eine Öffnung 21 in der Verschlussplatte 11 hinein, wobei die Öffnung 21 eine Aufweitung 22 aufweist. Die Verschlussplatte 11 lässt sich nur dann gemäß Pfeil 13 verschieben, wenn die Mitnehmerplatte 10 so verschoben ist, dass die Nase 20 in die Aufweitung 22 hinein ausweichen kann.

In Fig. 2 weist das Bezugszeichen 70 auf zwei verschieden farbige Felder auf der Mitnehmerplatte 10 hin, z.B. ein grünes und ein rotes Feld. Je nach Stellung der Mitnehmerplatte 10 ist eines der beiden Felder durch ein Fenster 71 in der Verschlussplatte 11 und ein Fenster 72 in der Zählertragplatte 4 hindurch sichtbar.

Wie Fig. 2 ferner erkennen lässt, ist in der Zählertragplatte 4 eine Öffnung 73 für ein Steckschloss 75 vorgesehen, welches sich in einen Schacht 74 im Kastenteil 5 einschieben und befestigen lässt. Im eingeschobenen Zustand bildet das Steckschloss einen Anschlag für eine mit der Mitnehmerplatte 10 verbundene Zunge 76, welcher eine Verschiebung der Mitnehmerplatte 10 verhindert.

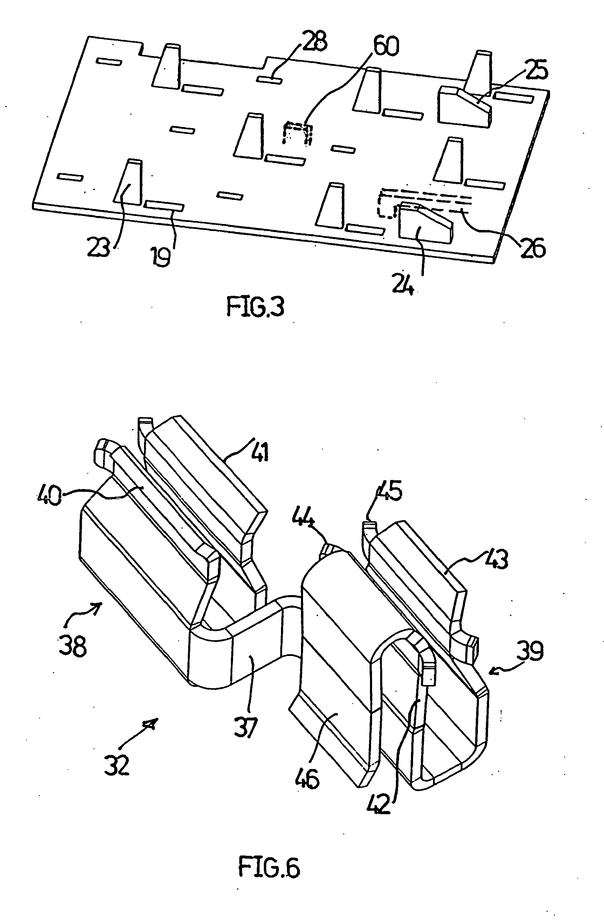

Wie Fig. 3 erkennen lässt, weist die Mitnehmerplatte 10 auf ihrer den Isolierteilen 9 zugewandten Seite bei jedem der Schlitze 19 einen zu dem betreffenden Schlitz in Verschiebungsrichtung gemäß Pfeil 12 ausgerichteten Vorsprung 23 auf, dessen Stärke etwa gleich der Stärke der streifenförmigen Kontaktelemente ist, welche von dem Stromzähler durch die Schlitze 19 hindurch vorstehen.

Zwei weitere, in Richtung des Pfeils 12 zu den Schlitzen 19 ausgerichtete Vorsprünge 24 bilden ein Widerlager für einen flexiblen, mit dem unteren Gehäuseteil 4 verbundenen Haken 26. Wie Fig. 3 erkennen lässt, weisen die Vorsprünge 24 jeweils eine Schräge 25 auf. Es könnten auch drei oder maximal sechs solcher Verhakungen vorgesehen sein.

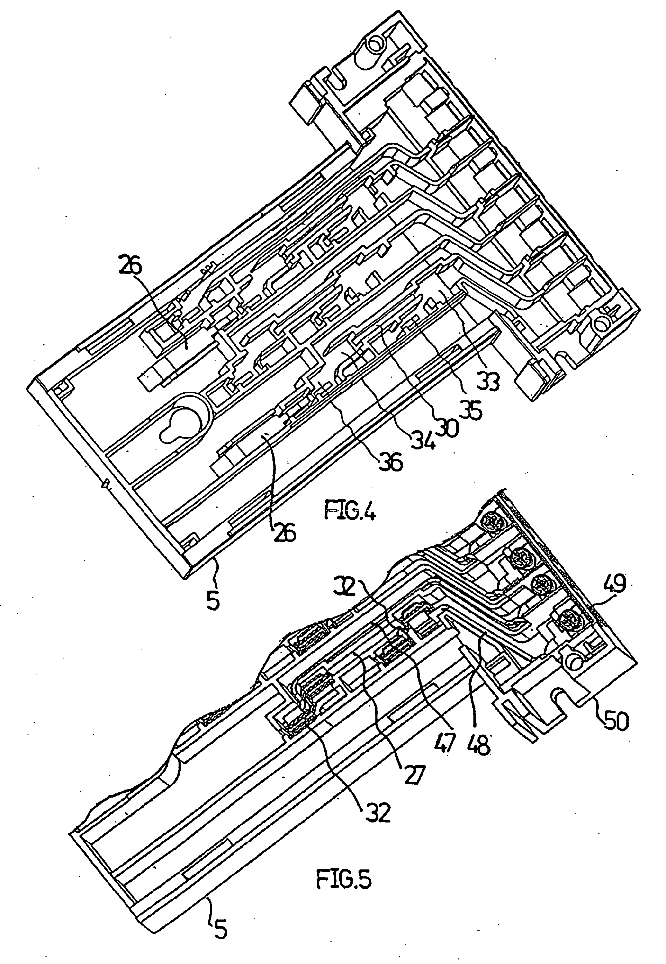

In weitere Schlitzöffnungen 28 in der Mitnehmerplatte 10 greifen Nasen 29 ein, welche von drei Überbrückungsteilen 27 für drei Stromphasen vorstehen. Wie Fig. 4 erkennen lässt, sind drei Führungen 30 für jeweils ein in Richtung des Pfeils 12 verschiebbares Überbrückungsteil 27 vorgesehen. Wenn kein Stromzähler angeschlossen ist, stehen beide Enden der Überbrückungsteile 27 in elektrischer Verbindung mit einem Kontaktstück 32, das in Fig. 6 gesondert dargestellt ist. Wie durch Strichlinien angedeutet ist, könnten von der Mitnehmerplatte 10 auch Nasen 60 vorstehen, welche jeweils in eine Randausnehmung 61 im Überbrückungsteil 27 eingreifen oder gegen eine Randabwinklung 62 am Überbrückungsteil anschlagen.

An den Enden der Führungen 30 befindet sich im hinteren Gehäuseteil 3 jeweils eine Kammer 33 bzw. 34, welche in Verbindung mit einer weiteren Kammer 35 bzw. 36 steht. Die verbundenen Kammern 33 und 35 sowie die verbundenen Kammern 34 und 36 nehmen jeweils ein Kontaktstück 32 auf.

Jedes Kontaktstück 32 besteht aus zwei bei 37 miteinander verbundene Abschnitten 38 und 39, welche jeweils ein Paar von Federkontaktschenkeln 40 und 41 bzw. 42 und 43 bilden. Die Abschnitte 38 und 39 sind in Richtung des Pfeils 13 zueinander versetzt. Gespreizte Führungsnasen 44 und 45 erleichtern die seitliche Einführung des Überbrückungsteils 27 bzw. der vom Stromzähler vorstehenden Kontaktelemente in den Zwischenraum zwischen den Federkontaktschenkeln.

An den Federkontaktschenkel 42 der einteiligen Kontaktstücke schließt sich ein den Abschnitt 39 des Kontaktelements 32 im Querschnitt von der U-Form zu einer S-Form erweiternder Federkontaktschenkel 46 an, welcher mit dem Federkontaktschenkel 42 ein Schenkelpaar zur Kontaktierung eines Anschlussleiterstücks 47 bzw. 48 (Fig. 5) bildet. Die gebogenen, zwischen isolierenden Stegen verlegten Anschlussleiterstücke 47,48 sind jeweils zu einem Klemmanschlusselement 49 an dem Anschlussleistenteil 50 des Adapters 1 geführt. Der Federkontaktschenkel 46 könnte auch nichtfedernd und zum Verbinden, z.B. durch Verschweißen oder Verkrimpen, mit einem Anschlussleiter vorgesehen sein.

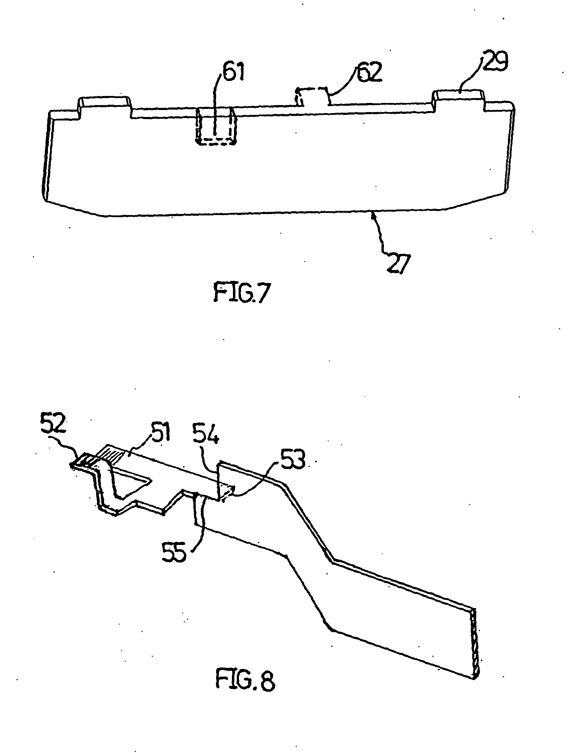

Fig. 8 zeigt einen an das Klemmanschlusselement 49 anzuschließenden Endteil des Anschlussleiterstücks 47 bzw. 48 mit Anschlussfahnen 51 und 52. Das Leiterstück ist aus einem Blechstanzteil hergestellt, in den am Rand ein Einschnitt unter Bildung von Schnittkanten 53 und 54 erfolgte, um bei 55 eine Abkantung vornehmen zu können, in dem gezeigten Ausführungsbeispiel um 90°.

Im folgenden wird die Funktionsweise der vorangehend beschriebenen Anschlussvorrichtung erläutert.

Im Anlieferungszustand der vorangehend beschriebenen Anschlussvorrichtung, in welcher kein Stromzähler angeschlossen ist, sind die Überbrückungen geöffnet und die Schlitze 14 in der Zählertragplatte 4 durch die Verschlussplatte 11 verschlossen. Die Verschlussplatte 11 ist nicht plombiert.

Bei der Montage eines Stromzählers wird die Verschlussplatte 11 in Richtung des Pfeils 13 verschoben, um die Schlitze 14 zu öffnen. Die Überbrückungsteile 27 lassen sich nun mit Hilfe eines speziellen Werkzeugs, das ähnlich dem Bodenteil eines Zählers ausgebildet sein kann, in die Überbrückungsposition verschieben. Nach Entfernen des Werkzeugs kann der Zähler aufgesetzt, parallel zur Tragplatte in die Anschlussposition verschoben und in der Anschlussposition plombiert werden.

Bei einem Zählerwechsel wird die Plombe entfernt und der Zähler nach Verschiebung parallel zur Zählertragplatte in der Tragplatte abgenommen und dann ein neuer Zähler angeschlossen und plombiert.

Um die Anlage außer Betrieb zu setzen, werden bei abgenommenen Zähler mit Hilfe des genannten Werkzeugs die Überbrückungsteile 27 in die Offenstellung verschoben, die Schlitze 14 mit Hilfe der Verschlussplatte 11 verschlossen und plombiert.

Befindet sich kein Zähler auf der Tragplatte, so stehen, außer im Anlieferungszustand und bei Stilllegung, die Überbrückungsteile 27 an beiden Enden in Verbindung mit einem Kontaktstück 32. Die Leiterstücke 47 und 48 sind durch die Überbrückungsteile 27 elektrisch miteinander verbunden. Jede Phase ist kurzgeschlossen.

Wird die Verschlussplatte gemäß Pfeil 13 verschoben, bewegt sich die Nase 20 auf der Mitnehmerplatte 10 aus der Aufweitung 22 der Öffnung 21 heraus und ist nun in Längsrichtung in der Öffnung 21 verschiebbar.

Wird der Stromzähler senkrecht auf die Zählertragplatte 4 aufgesetzt, treten die Kontaktelemente durch die Schlitze 14 in der Tragplatte, die Schlitze 18 in der Verschlussplatte und die Schlitze 19 in der Mitnehmerplatte hindurch. In dieser Position sind die Kontaktelemente des Stromzählers noch elektrisch von den Kontaktstücken 32 getrennt, wobei die Vorsprünge 23 an der Mitnehmerplatte 10 für eine sichere Isolierung der Kontaktelemente gegen die Kontaktstücke 32 sorgen.

Sitzt der Stromzähler korrekt auf der Tragplatte 4 auf, so sind durch dessen betreffende Kontaktelemente die Haken 26 in Richtung Boden des Kastenteils 5 gedrückt, so dass die Haken 26 die Vorsprünge 24 an der Mitnehmerplatte 10 nicht mehr hintergreifen. Der Zähler kann nun in Richtung zum Leistenteil 50 gemäß Pfeil 12 verschoben werden. Dabei nehmen die Kontaktelemente, deren Breite gleich der Länge der Schlitze 19 ist, die Platte 10 mit, welcher ihrerseits die Überbrückungsteile 27, welche mit ihren Nasen 29 in die Schlitzöffnungen 28 an der Mitnehmerplatte eingreifen, verschiebt. Bei diesem Vorgang wird die Überbrückung aufgehoben, während die betreffenden Kontaktelemente des Stromzählers an die nicht mehr überbrückten Kontaktstücke 32 angeschlossen werden. In einer Überbrückungsphase bestehen der Anschluss und die Überbrückung gleichzeitig.

In der Anschlussstellung der Stromzähler sind alle Öffnungen der Zählertragplatte durch den Stromzähler selbst verschlossen. Einrichtungen zur Arretierung und Plombierung des Stromzählers sind in den Figuren nicht gezeigt.

Bei der Demontage wird der Zähler in umgekehrter Richtung verschoben, wobei eine Loslösung der Kontaktelemente des Stromzählers von den Kontaktstücken 32 und Wiederherstellung der Überbrückungen durch die Teile 27 erfolgt. Bei der Rückverschiebung gleitet der Haken 26 über die Schrägen 25 der Vorsprünge 24. Wird der Zähler von der Tragplatte abgenommen, so hintergreift der Haken 26 wieder die Vorsprünge 24. Die Mitnehmerplatte 10 lässt sich nicht mehr gemäß Pfeil 12 verschieben.

Vorteilhaft können durch die in Richtung senkrecht zu den Platten 10,11 vorstehenden Federkontaktschenkel die Kontaktpunkte relativ nahe an den Platten liegen, so dass kurze Kontaktelemente am Stromzähler ausreichen, um die Anschlussverbindungen herzustellen.

Je nachdem, ob die stromzu- und -abführenden Leiter überbrückt sind oder nicht, ist bei abgesetztem Zähler durch die Fenster 71 und 72 hindurch eines der beiden Felder 70 auf der Mitnehmerplatte 10 sichtbar. Somit wird die Schaltstellung angezeigt.

Solange das Steckschloss 75 in dem Schacht 74 sitzt, lässt sich die Mitnehmerplatte 10 aus der Position, in welcher die Überbrückung aufgehoben ist, nicht verschieben.

Das Steckschloss 75 dient auch zur Arretierung und Sicherung des aufgesetzten Zählers, der wegen der Arretierung der Mitnehmerplatte auf der Tragplatte nicht verschiebbar ist. Wenn keine Mitnehmerplatte vorhanden ist, kann das Steckschloss den Zähler arretieren, indem es aus der Öffnung 73 vorsteht und einen Anschlag für das Zählergehäuse bildet. Abweichung von dem gezeigten Beispiel könnte das Steckschloss auch seitlich in den Kastenteil einführbar sein.

Ein solches Steckschloss ließe sich auch an einem für den Einsatz der betreffenden Zähler vorbereiteten Zählerplatz verwenden.

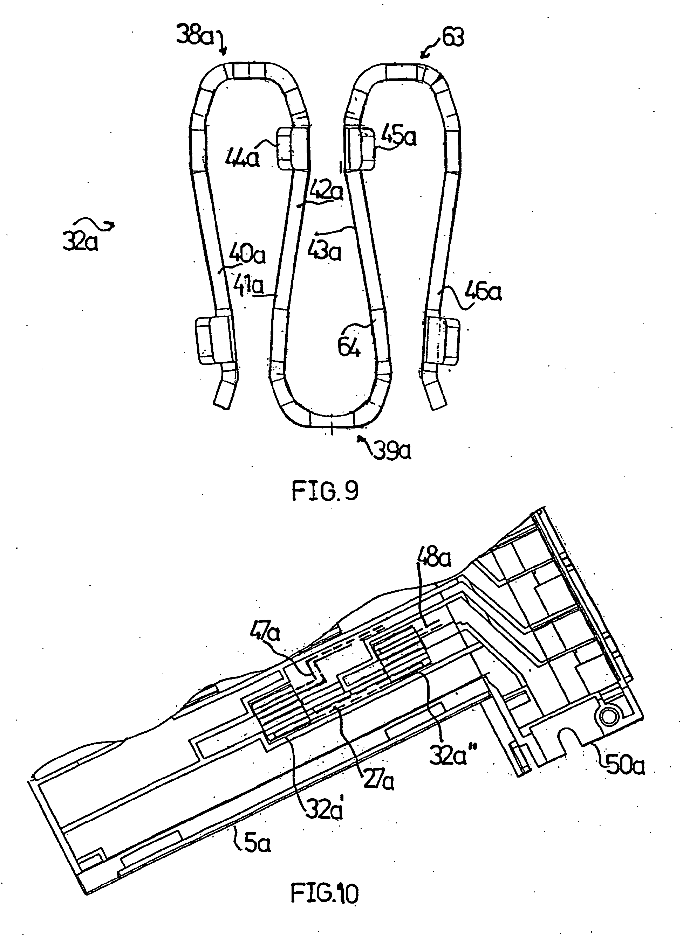

Es wird nun auf die Fig. 9 und 10 Bezug genommen, die sich auf ein weiteres Ausführungsbeispiel für eine Anschlussvorrichtung beziehen. Gleiche oder gleichwirkende Teile sind mit derselben Bezugszahl wie in den vorangehenden Figuren bezeichnet, wobei der betreffenden Bezugszahl der Buchstabe a beigefügt ist.

Ein in Fig. 9 gesondert dargestelltes, aus einem Federmaterialstreifen hergestellten Kontaktelement 32a weist einen U-förmigen Abschnitt 38a mit Federkontaktschenkeln 40a und 41 a sowie einen U-förmigen Abschnitt 39a mit Federkontaktschenkeln 42a und 43a auf. Die beiden U-förmigen Abschnitte bilden in der in Fig. 9 gezeigten Ansicht eine S-Form, wobei der Federkontaktschenkel 42a des U-förmigen Abschnitts 39a in den Federkontaktschenkel 41 a des U-förmigen Abschnitts 38a übergeht. An den U-förmigen Abschnitt 39a schließt sich ein weiterer U-förmiger Abschnitt 63 mit einem Federkontaktschenkel 64 und einem Federkontaktschenkel 46a an. Der Federkontaktschenkel 64 geht in den Federkontaktschenkel 43a des U-förmigen Abschnitts 39a über. Mit 44a und 45a sind an den Federkontaktschenkeln 42a und 43a angebrachte Führungsnasen bezeichnet.

Weitere solche Führungsnasen sind an den Federkontaktschenkeln 40a und 46a vorgesehen.

Fig. 10 zeigt einen Kastenteil 5a eines Adaptergehäuses, in welche dem Kontaktstück von Fig. 9 entsprechende Kontaktstücke 32a' und 32a" eingesetzt sind. Zwischen den Federkontaktschenkeln 46a und 64 des Federkontaktstücks 32a' ist ein (nur teilweise dargestelltes) Leiterstück 47a angeschlossen, das zu einer Anschlussleiste 50a geführt ist. Die entsprechenden Federkontaktschenkel des Kontaktstücks 32a" stehen in Verbindung mit einem zu der Leiste 50a geführten (nur teilweise dargestellten) Leiterstück 48a.

Die jeweiligen Federkontaktschenkel 40a und 41 a dienen zur Anklemmung eines Überbrückungsteils 27a. Zwischen den jeweiligen Federkontaktschenkeln 42a und 43a kommt ein vom Stromzähler vorstehendes Kontaktelement zum Anschluss.

Die Baulänge des Kontaktstücks 32a in Verschiebungsrichtung des Stromzählers ist gegenüber der Baulänge des Kontaktstücks 32 um etwa die Hälfte verkürzt. Infolge kürzerer Stromwege verringert sich der Eigenwiderstand entsprechend.

Der Federkontaktschenkel 46a könnte auch nichtfedernd und zur Verbindung mit einem Anschlussleiter z.B. durch Verschweißen oder Verkrimpen vorgesehen sein.

## Patentansprüche

1. Anschlussvorrichtung für einen Stromzähler, der ein Gehäuse aufweist, von dessen gegen eine Tragplatte (4) anlegbarem Boden durch Öffnungen (14) in der Tragplatte (4) hindurchführbare Kontaktelemente entsprechend wenigstens einer Stromphase vorstehen, welche durch Verschiebung des auf der Tragplatte (4) geführten Gehäuses mit stromzu- und -abführenden Anschlusselementen (32) auf der dem Stromzähler abgewandten Seite der Tragplatte (4) verbindbar sind, wobei die Anschlusselemente (32,47,48) durch ein in Verschiebungsrichtung des Stromzählers verschiebbar geführtes Teil (27) überbrückbar sind und das Überbrückungsteil (27) beim Anschluss des Stromzählers durch den Stromzähler aus einer Überbrückungsposition in eine Offenstellung verschiebbar ist,
**dadurch gekennzeichnet,**
**dass** das Überbrückungsteil (27) und das wenigstens eine Kontaktelement senkrecht zur Verschiebungsrichtung des Zählergehäuses zueinander versetzt angeordnet sind und das Überbrückungsteil (27.) durch den Stromzähler mittelbar über ein Zwischenstück (10) verschiebbar ist.

2. Anschlussvorrichtung nach Anspruch 1,
**dadurch gekennzeichnet,**
**dass** das Zwischenstück eine Öffnungen (19) für die Kontaktelemente aufweisende, zur Tragplatte (4) parallele Platte (10) mit Einrichtungen (28) zur Mitnahme des Überbrückungsteils (27) umfasst.

3. Anschlussvorrichtung nach Anspruch 2,
**dadurch gekennzeichnet,**
**dass** zwischen der Mitnehmerplatte (10) und der Tragplatte (4) eine weitere, quer zur Verschiebungsrichtung des Stromzählers bewegbare Verschlussplatte (11) zum Verschließen von zu den Anschlusselementen (32,47,48) führenden Durchgängen durch die Platten (4,10) vorgesehen ist.

4. Anschlussvorrichtung nach Anspruch 3,
**dadurch gekennzeichnet,**
**dass** die Verschlussplatte (11) in der Verschlussstellung plombierbar ist.

5. Anschlussvorrichtung nach einem der Ansprüche 1 bis 4,
**dadurch gekennzeichnet,**
**dass** die stromzu- und -abführenden Anschlusselemente (32,47,48) sich senkrecht zur Verschiebungsrichtung des Zählergehäuses erstreckende Federkontaktschenkel (40-43) aufweisen.

6. Anschlussvorrichtung nach Anspruch 5,
**dadurch gekennzeichnet,**
**dass** zwei senkrecht zur Verschiebungsrichtung des Zählergehäuses zueinander versetzte Paare von Federkontaktschenkeln (40,41;42,43) an einem einteiligen Kontaktstück (32) gebildet sind.

7. Anschlussvorrichtung nach Anspruch 6,
**dadurch gekennzeichnet,**
**dass** an einem der Paare von Federkontaktschenkeln (42,43) ein weiterer Federschenkel (46) vorgesehen ist, welcher mit einem (42) der beiden Federkontaktschenkel (42,43) des Paares einen Kontaktschlitz für einen Anschlussleiter (47,48) bildet.

8. Anschlussvorrichtung nach einem der Ansprüche 2 bis 7,
**dadurch gekennzeichnet,**
**dass** an der Mitnehmerplatte (10) in Verschiebungsrichtung ausgerichtet zu den Öffnungen (19) die Anschlusselemente (32) vor der Kontaktierung gegen die Kontaktelemente des Stromzählers isolierende Vorsprünge (23) gebildet sind.

9. Anschlussvorrichtung nach einem der Ansprüche 5 bis 8,
**dadurch gekennzeichnet,**
**dass** an den Federkontaktschenkeln (40-43) die seitliche Einführung des Kontaktelements bzw. des Überbrückungsteils (27) erleichternde Leiteinrichtungen (44,45) gebildet sind.

10. Anschlussvorrichtung nach einem der Ansprüche 1 bis 9,
**dadurch gekennzeichnet,**
**dass** eine unerwünschte Verschiebungen der Mitnehmerplatte (10) verhindernde, beim Aufsetzen des Stromzählergehäuses auf die Tragplatte (4) durch die Kontaktelemente lösbare Verhakung (26) vorgesehen ist.

11. Anschlussvorrichtung nach einem der Ansprüche 1 bis 10,
**dadurch gekennzeichnet,**
**dass** die Anschlusselemente Anschlussleiter (47,48) aufweisen, welche durch ein Blechstanzteil gebildet sind, wobei an einem Ende wenigstens eine Kontaktfahne (51,52) in Form einer bis zu einem Randeinschnitt (53,54) heranreichenden Abkantung (55) gebildet ist.

12. Anschlussvorrichtung nach einem der Ansprüche 6 bis 11,
**dadurch gekennzeichnet,**
**dass** es sich bei dem einteiligen Kontaktstück (32a) um einen S-förmig gebogenen Federmaterialstreifen handelt.

13. Anschlussvorrichtung nach Anspruch 12,
**dadurch gekennzeichnet,**
**dass** das einteilige Kontaktstück (32a) unter Bildung dreier Federkontaktschenkelpaare (38a,39a,63) doppelt S-förmig gebogen ist.

14. Anschlussvorrichtung nach einem der Ansprüche 1 bis 13,
**dadurch gekennzeichnet,**
**dass** das Zwischenstück (10) in der Offenstellung des Überbrückungsteils (27) arretierbar ist.

15. Anschlussvorrichtung nach Anspruch 14,
**dadurch gekennzeichnet,**
**dass** der Zähler in der Betriebsstellung über das Zwischenstück (10) arretierbar ist.

16. Anschlussvorrichtung nach Anspruch 14 oder 15,
**dadurch gekennzeichnet,**
**dass** zur Arretierung ein an der Anschlussvorrichtung festlegbares Steckschloss (75) vorgesehen ist.

17. Anschlussvorrichtung nach Anspruch 16,
**dadurch gekennzeichnet,**
**dass** das festgelegte Steckschloss (75) einen Anschlag für das Zwischenstück (10) bzw. den Zähler bildet.

## Claims

1. Connection apparatus for an electricity meter which has a housing, with contact elements which can be guided through openings (14) in the mounting plate (4) projecting from the base of said housing, which base can be attached to a mounting plate (4), in accordance with at least one current phase, and which contact elements can be connected to current-feeding and current-discharging connection elements (32) on that side of the mounting plate (4) which is averted from the electricity meter by displacement of the housing which is guided on the mounting plate (4), it being possible for the connection elements (32, 47, 48) to be bridged by a part (27) which is guided such that it can be displaced in the displacement direction of the electricity meter, and it being possible for the bridging part (27) to be displaced out of a bridging position and into an open position by the electricity meter when the electricity meter is connected,
**characterized**
**in that** the bridging part (27) and the at least one contact element are arranged so as to be offset to one another perpendicular to the displacement direction of the meter housing, and the bridging part (27) can be displaced by the electricity meter indirectly by means of an intermediate piece (10).

2. Connection apparatus according to Claim 1, **characterized in that** the intermediate piece comprises a plate (10) which has openings (19) for the contact elements, runs parallel to the mounting plate (4) and has devices (28) for driving the bridging part (27).

3. Connection apparatus according to Claim 2, **characterized in that** a further closure plate (11), which can move transverse to the displacement direction of the electricity meter, for closing passages through the plate (4, 10) which lead to the connection elements (32, 47, 48) is provided between the driver plate (10) and the mounting plate (4).

4. Connection apparatus according to Claim 3, **characterized in that** the closure plate (11) can be sealed in the closure position.

5. Connection apparatus according to one of Claims 1 to 4, **characterized in that** the current-feeding and current-discharging connection elements (32, 47, 48) have spring contact limbs (40-43) which extend perpendicular to the displacement direction of the meter housing.

6. Connection apparatus according to Claim 5, **characterized in that** two pairs of spring contact limbs (40, 41; 42, 43) which are offset in relation to one another perpendicular to the displacement direction of the meter housing are formed on an integral contact piece (32).

7. Connection apparatus according to Claim 6, **characterized in that** a further spring limb (46) is provided on one of the pairs of spring contact limbs (42, 43), the said spring limb forming a contact slot for a connection conductor (47, 48) with one (42) of the two spring contact limbs (42, 43) of the pair.

8. Connection apparatus according to one of Claims 2 to 7, **characterized in that** the connection elements (32) are formed on the driver plate (10) aligned with the openings (19) in the displacement direction before contact is made with projections (23) which provide isolation from the contact elements of the electricity meter.

9. Connection apparatus according to one of Claims 5 to 8, **characterized in that** guide devices (44, 45), which facilitate the lateral insertion of the contact element or of the bridging part (27), are formed on the spring contact limbs (40-43).

10. Connection apparatus according to one of Claims 1 to 9, **characterized in that** a hook system (26), which prevents undesired displacements of the driver plate (10) and can be released by the contact elements when the electricity meter housing is positioned on the mounting plate (4), is provided.

11. Connection apparatus according to one of Claims 1 to 10, **characterized in that** the connection elements have connection conductors (47, 48) which are formed by a punched sheet metal part, with at least one contact lug (51, 52) in the form of a bent edge (55) which reaches as far as an edge incision (53, 54) being formed at one end.

12. Connection apparatus according to one of Claims 6 to 11, **characterized in that** the integral contact piece (32a) is a strip of spring material which is bent into an S shape.

13. Connection apparatus according to Claim 12, **characterized in that** the integral contact piece (32a) is bent into the shape of a double S so as to form three pairs (38a, 39a, 63) of spring contact limbs.

14. Connection apparatus according to one of Claims 1 to 13, **characterized in that** the intermediate piece (10) can be locked in the open position of the bridging part (27).

15. Connection apparatus according to Claim 14, **characterized in that** the meter can be locked in the operating position by means of the intermediate piece (10).

16. Connection apparatus according to Claim 14 or 15, **characterized in that** a key lock (75) which can be fixed to the connection apparatus is provided for locking purposes.

17. Connection apparatus according to Claim 16, **characterized in that** the fixed key lock (75) forms a stop for the intermediate piece (10) or the meter.

## Revendications

1. Dispositif de branchement pour un compteur électrique, qui comprend un boîtier dont le fond peut être appliqué contre une plaque porteuse (4), avec des éléments de contact, correspondant à au moins une phase du courant, qui dépassent depuis le fond du boîtier et peuvent être passés à travers des ouvertures (14) dans la plaque porteuse (4), lesdits éléments de contact pouvant être reliés, par translation du boîtier guidé sur la plaque porteuse (4), avec des éléments de branchement (32) destinés à l'arrivée et au départ du courant sur le côté de la plaque porteuse (4) détourné du compteur électrique, dans lequel les éléments de branchement (32, 47, 48) peuvent être pontés par une pièce (27) guidée en translation dans la direction de translation du compteur électrique, et la pièce de pontage (27) est déplaçable par le compteur électrique, lors du branchement du compteur électrique, depuis une position de pontage jusque dans une position d'ouverture,
**caractérisé en ce que** la pièce de pontage (27) et ledit au moins un élément de contact sont agencés en décalage l'une par rapport à l'autre perpendiculairement à la direction de translation du boîtier de compteur, et la pièce de pontage (27) est déplaçable par le compteur électrique de façon indirecte via une pièce intermédiaire (10).

2. Dispositif de branchement selon la revendication 1,
**caractérisé en ce que** la pièce intermédiaire comprend une plaque (10), parallèle à la plaque porteuse (4) et présentant des ouvertures (19) pour les éléments de contact, avec des moyens (28) pour l'entraînement de la pièce de pontage (27).

3. Dispositif de branchement selon la revendication 2,
**caractérisé en ce qu'**il est prévu une autre plaque de fermeture (11) entre la plaque d'entraînement (10) et la plaque porteuse (4), déplaçable perpendiculairement à la direction de translation du compteur électrique, pour refermer des passages à travers les plaques (4, 10) qui mènent vers les éléments de branchement (32, 47, 48).

4. Dispositif de branchement selon la revendication 3,
**caractérisé en ce que** la plaque de fermeture (11) est susceptible d'être plombée dans la position de fermeture.

5. Dispositif de branchement selon l'une des revendications 1 à 4,
**caractérisé en ce que** les éléments de branchement (32, 47, 48) destinés à l'arrivée et au départ du courant comprennent des branches de contact élastiques (40-43) qui s'étendent perpendiculairement à la direction de translation du boîtier de compteur.

6. Dispositif de branchement selon la revendication 5,
**caractérisé en ce que** deux paires de branches de contact élastiques (40, 41 ; 42, 43), décalées l'une par rapport à l'autre perpendiculairement à la direction de translation du boîtier de compteur, sont formées sur une pièce de contact (32) d'un seul tenant.

7. Dispositif de branchement selon la revendication 6,
**caractérisé en ce qu'**une autre branche élastique (46) est prévue sur l'une des paires de branches de contact élastique (42, 43), laquelle forme, avec l'une (42) des deux branches de contact élastiques (42, 43) de la paire, une fente de contact pour une ligne de branchement (47,48).

8. Dispositif de branchement selon l'une des revendications 2 à 7,
**caractérisé en ce que** des saillies (23) sont formées sur la plaque d'entraînement (10) orientées dans la direction de translation vers les ouvertures (19), ces saillies isolant les éléments de branchement (32) vis-à-vis d'une venue en contact contre les éléments de contact du compteur électrique.

9. Dispositif de branchement selon l'une des revendications 5 à 8,
**caractérisé en ce que** des moyens de guidage (44, 45), qui facilitent l'introduction latérale de l'élément de contact ou de la pièce de pontage (27), sont formés sur les branches de contact élastiques (40-43).

10. Dispositif de branchement selon l'une des revendications 1 à 9,
**caractérisé en ce qu'**il est prévu un moyen d'accrochage (26), susceptible d'être détaché par les éléments de contact lors de la pose du boîtier du compteur électrique sur la plaque porteuse (4), qui empêche des translations indésirées de la plaque d'entraînement (10).

11. Dispositif de branchement selon l'une des revendications 1 à 10,
**caractérisé en ce que** les éléments de branchement comprennent des lignes de branchement (47, 48), qui sont formées par une pièce en tôle poinçonnée, dans laquelle au moins une patte de contact (51, 52), sous la forme d'un rabattement (55) qui s'étend jusqu'à une entaille de bordure (53, 54) est formée à une extrémité.

12. Dispositif de branchement selon l'une des revendications 6 à 11,
**caractérisé en ce que** la pièce de contact d'un seul tenant (32a) est un ruban de matériau élastique cintré en forme de S.

13. Dispositif de branchement selon la revendication 12,
**caractérisé en ce que** la pièce de contact d'un seul tenant (32a) est cintrée deux fois en forme de S en formant trois paires de branches de contact élastiques (38a, 39a, 63).

14. Dispositif de branchement selon l'une des revendications 1 à 13,
**caractérisé en ce que** la pièce intermédiaire (10) est susceptible d'être arrêtée dans la position ouverte de la pièce de pontage (27).

15. Dispositif de branchement selon la revendication 14,
**caractérisé en ce que** le compteur est susceptible d'être arrêté par la pièce intermédiaire (10) dans la position de service.

16. Dispositif de branchement selon la revendication 14 ou 15,
**caractérisé en ce qu'**il est prévu un verrou à enfichage (75) susceptible d'être immobilisé sur le dispositif de branchement pour l'arrêt.

17. Dispositif de branchement selon la revendication 16,
**caractérisé en ce que** le verrou à enfichage (75) susceptible d'être immobilisé forme une butée pour la pièce intermédiaire (10) ou le compteur.
